# EUROPEAN PATENT APPLICATION

(11) **EP 1 049 163 A1**
(43) Date of publication of application: **02.11.2000**
(21) Application number: 99108252.0
(22) Date of filing: 27.04.1999
(51) Int. Cl.: H01L 23/498

(54) **Multiple line grid array package and a method for the manufacture thereof**

(71) Applicant: GLOTECH INC. Seoul Business Incubator, Kangseo-Gu, Seoul (KR)
(72) Inventor: Yoon, Chong Kwang, Seongnam-Shi, Kyounggi-Do (KR); Kim, Chan Keun, Ryongchang-Dong, Chongno-Ku, Seoul (KR)
(74) Representative: Niederkofler, Oswald A. Dipl.-Phys.

(57) **Abstract**

A multiple line grid array package includes: a package body having a first surface and a second surface opposite to the first surface; a first pattern formed on the first surface of the package body and including a number of input/output nodes; a second pattern formed on the second surface of the package body; and a multiple line grid having a nonconductive grid body and a number of conductors formed parallel to a longitudinal axis of the nonconductive grid body on the outer peripheral portion and/or within the inner portion of the multiple line grid and bonded to the package body; wherein each of conductors is electrically isolated from each other and matches the corresponding one of the number of input/output nodes of the first pattern.

## Description

The present invention relates to a multiple line grid array package(MLGA package); and, more particularly, to the multiple line grid array package on which a semiconductor chip is equipped and input/output nodes for supplying electrical signals to the semiconductor chip are exposed, the multiple line grid array package having a package body with electrical circuit patterns according to specific design rules, and multiple line grids which electrically connect the input/output nodes with a power source, and a method for the manufacture thereof.

Generally, a ceramic pin grid array package (PGA) includes a multilayer ceramic structure and cylindrical metallic leads which are attached on the multilayer ceramic structure.

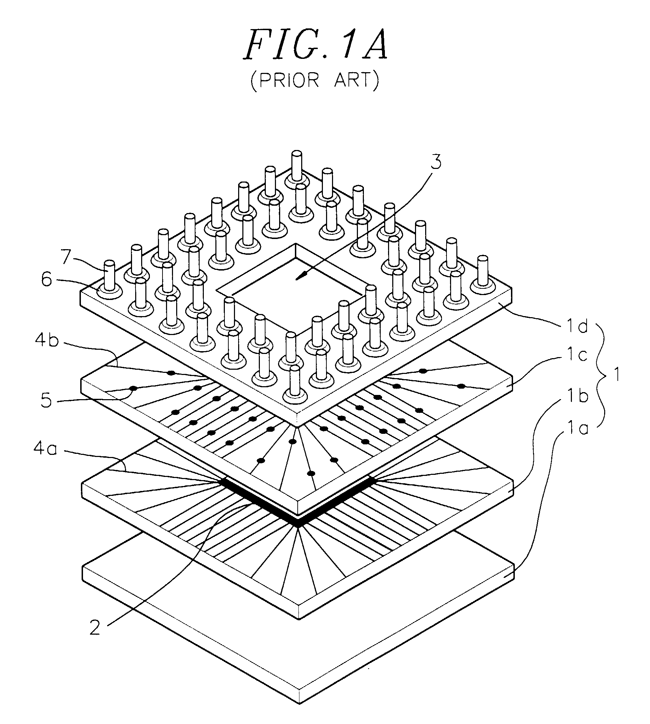

Fig. 1A to 1C are shown an example of a conventional ceramic package which has the structure as described above.

As shown in Fig. 1A, there is provided a multilayer ceramic structure (package body 1) which includes, for example, four ceramic layers, namely, a first , a second, a third and a fourth ceramic layers 1a, 1b, 1c and 1d. Here, the first ceramic layer la located at the very bottom of the four ceramic layers is a dummy layer, and at the center portion of the second ceramic layer 1b is mounted a semiconductor chip 2. First electrode lines 4a for transferring electrical signals to each part of the semiconductor chip 2 are printed around the semiconductor chip 2 on the upper face of the second ceramic layer 1b.

The third ceramic layer 1c is provided with a first cavity (not shown) which has a size capable of accommodating the semiconductor chip 2. Second electrode lines 4b are printed around the first cavity on the upper face of the third ceramic layer 1c. The fourth ceramic layer 1d is also provided with a second cavity which has a size capable of accommodating the semiconductor chip 2.

Around the second cavity 3 on the upper face of the fourth ceramic layer 1d, there are a plurality of input/output nodes 6 aligned apart from each other at regular intervals. In addition, a plurality of via holes (not shown) for electrically connecting the respective input/output nodes 6 with the corresponding first and second electrode lines 4a, 4b are formed in the second, third and fourth ceramic layers 1b, 1c, 1d. The via holes are filled with a conductive paste. In Fig. 1A, there are shown upper portions 5 of the via holes filled with the conductive paste. Accordingly, when the electrical signals are transferred to the input/output nodes 6, the electrical signals are continuously transferred through the first and second electrode lines 4a, 4b to terminals in the semiconductor chip 2.

Leads 7 for transferring the electrical signals are bonded to the package body 1. The leads 7 are typically made of a metal, and are formed into cylindrical pins. Furthermore, each of the leads 7 is connected with each of the corresponding input/output nodes 6.

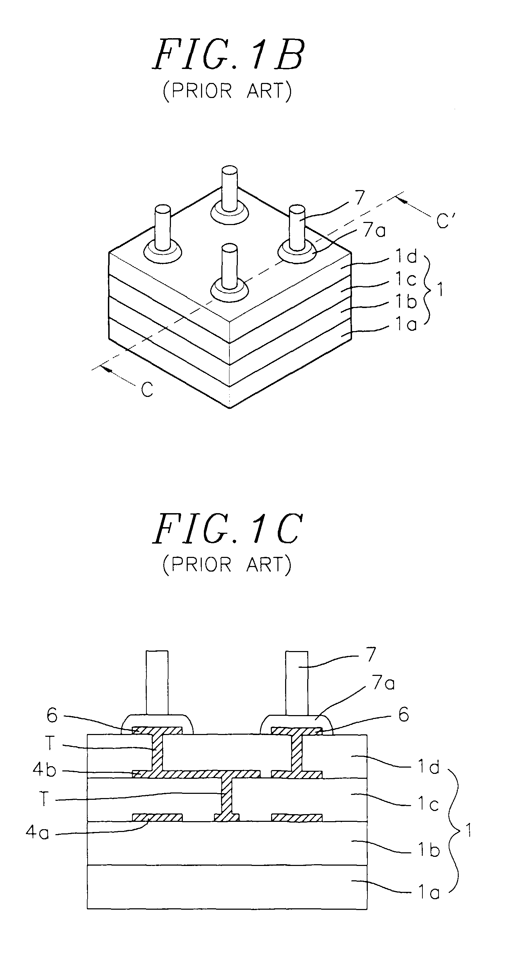

Fig. 1B is a partially enlarged view of the package body 1 in Fig. 1A. The leads 7 in the shape of pins are bonded to the corresponding input/output nodes 6 by brazing 7a.

Fig. 1C is a cross-sectional view along the line C-C' of Fig. 1B. The plurality of via holes are formed in the package body 1, and the via holes are filled with the conductive paste T. The respective ceramic layers 1a, 1b, 1c, 1d composing the package body 1 are provided with the first and second electrode lines 4a, 4b which are printed on the upper face of the ceramic layers 1a, 1b, 1c, 1d. The ceramic layers 1a, 1b, 1c, 1d are laminated on top of each other by pressing together and then fired at high temperatures.

However, the conventional pin grid array package as mentioned above is saddled with a number of problems.

First, since the leads 7 in pin shapes are respectively connected with the corresponding input/output nodes 6 on the upper face of the ceramic package body 1, the number of the leads 7 must be same as that of the input/output nodes 6. Therefore, the higher the semiconductor chip is integrated, the greater the number of the input/output nodes 6 is required. Such increase in the integration of the semiconductor chip causes the manufacturing cost of the ceramic package to increase, and the size of the package to also increase.

It is, therefore, an object of the present invention to provide a multiple line grid array package having a reduced size.

It is another object of the present invention to provide a method for manufacturing the multiple line grid array package.

In accordance with one aspect of the present invention, there is provided a multiple line grid array package comprising: a package body including at least a layer and having a first surface and a second surface opposite to the first surface; a first pattern formed on the first surface of the package body and including a number of input/output nodes; a second pattern formed on the second surface of the package body; and a multiple line grid having a nonconductive grid body and a number of conductors formed parallel to a longitudinal direction of the nonconductive grid body on the outer peripheral portion and/or within the inner portion of the multiple line grid and bonded to the package body, wherein each of conductors is electrically isolated from each other and matches corresponding one of the number of input/output nodes of the first pattern.

In accordance with another aspect of the present invention, there is provided a method for manufacturing the multiple line grid array package, the method comprising: a package body having a number of input/output nodes; and at least a multiple line grid having a nonconductive grid body and a number of conductors formed parallel to a longitudinal direction of the nonconductive grid body on the outer peripheral portion and/or within the inner portion of the multiple line grid, wherein each of conductors is electrically isolated from each other and is bonded to a corresponding input/output node in the number of input/output nodes.

The above and other objects and features of the present invention will be more apparent from the following description of the preferred embodiments given in conjunction with the accompanying drawings, wherein:
Figs. 1A to 1C are an exploded perspective view of a conventional pin grid array package, a partial perspective view of Fig. 1A and a cross-sectional view taken along a line C-C' of Fig. 1B, respectively;
Fig. 2 shows a schematic perspective view of one type of multiple line grid array packages in accordance with a preferred embodiment of the present invention;
Figs. 3A and 3B depict partially enlarged perspective views of two examples of multiple line grid in the multiple line grid array package of Fig. 2;
Figs. 4A to 4C illustrate other embodiments of multiple line grids which are to be applicable to the multiple line grid array package of Fig.2.
Fig. 5 presents a cross-sectional view taken along a line IV-IV' of Fig. 2;
Figs. 6A and 6B are plan views showing examples of electrical circuit patterns printed on bottom and top surfaces of the package body, respectively; and
Figs. 7A to 7C offer schematic perspective views showing one of the methods for manufacturing the multiple line grid in accordance with the present invention.

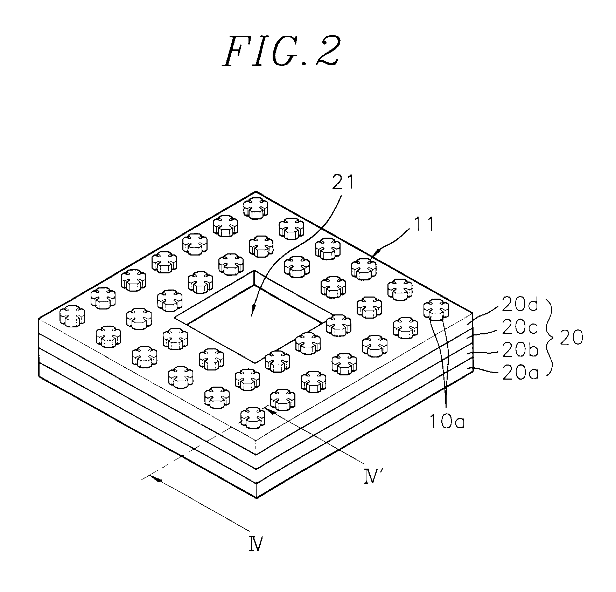

Referring now to Figs. 2 to 7, there are illustrated embodiments of the present invention.

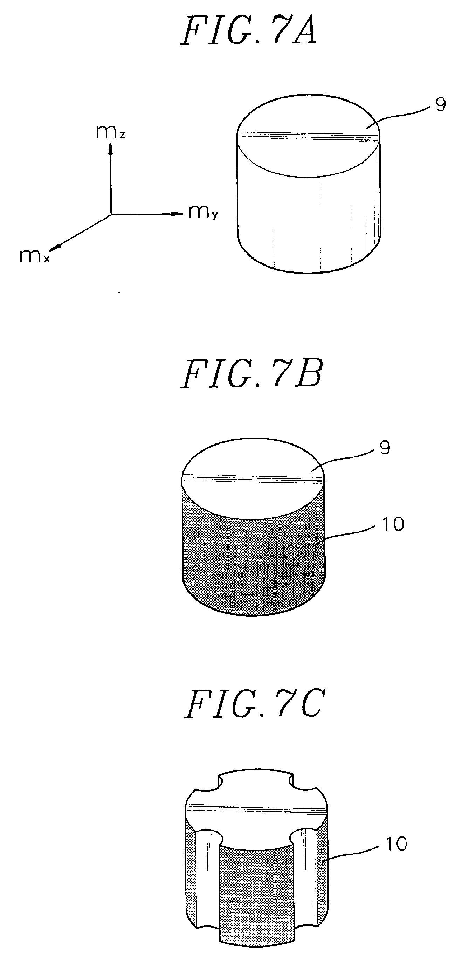

As shown in Figs. 2 to 7C, a reference numeral 9 designates a nonconductive body of various types of multiple line grids, and 10a is a conductor on the outer surface or interior of the body 9, and 11 is a multiple line grid comprising the nonconductive body 9 and the conductor 10a. In addition, reference numerals 20a, 20b, 20c, 20d designate the package layers which include metallic electrode lines and electrical contacts on ceramic layers or plastic layers. A reference numeral 20 indicates a package body including the package layers 20a, 20b, 20c, 20d stacked and electrically connected to each other, and a reference numeral 21 is a cavity for accommodating a semiconductor chip, and a reference numeral 22 is an input/output node which is arranged on the upper face of the package body 20, and a reference numeral 23 is a solder provided on each of the input/output node 22.

In the present invention, a semiconductor package, in which a plurality of input/output nodes is connected with one multiple line grid of multiple conductors in order to decrease the number of multiple line grids and the size of the package, is called "multiple line grid array package".

Referring to Fig. 2, the multiple line grid array package of the present invention is described herebelow. The body 20 of the multiple line grid array package is a structure formed by stacking up a number of, for example, four, package layers 20a, 20b, 20c, 20d. The input/output nodes 22 are exposed on the surface of the most upper package layer 20d, and are electrically connected with lower corresponding first and second electrode lines(not shown) in via contact manner. The package body 20 includes metallic electrode lines and electrical contacts on ceramic and/or plastic materials.

At the center of the package body 20, there is provided, if necessary, a cavity 21 for accommodating a semiconductor chip. However, the semiconductor chip may be located in other manners different from the one shown in Fig. 2. The multiple line grids 11 of the present embodiment are attached to input/output nodes 22, and receive the electrical signals from an external power source(not shown). Each of the multiple line grids 11 is attached to a number of input/output nodes 22 by soldering process which is cheaper than brazing process. That is, for example, the multiple line grid 11 in the present embodiment connects a number of, for example, eight, input/output nodes 22.

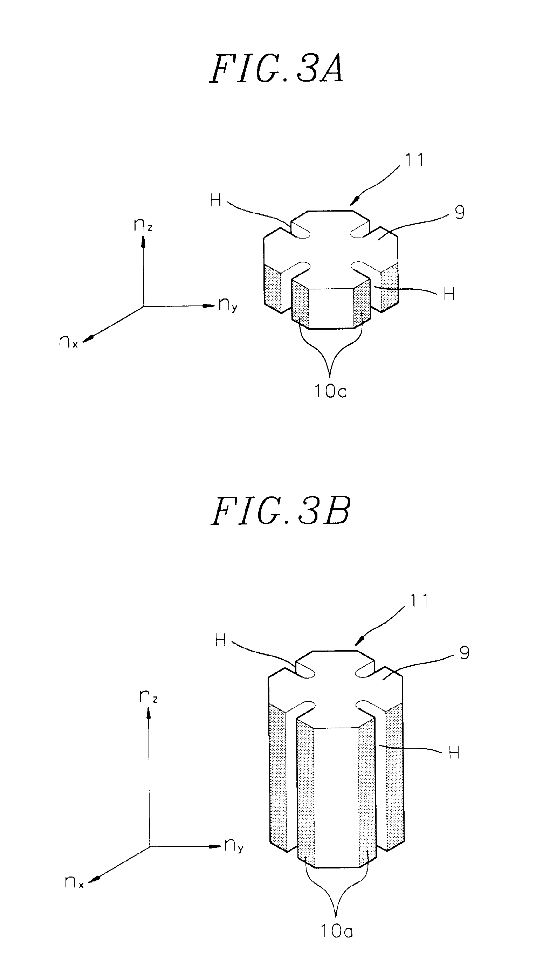

Referring to Figs. 3 to 4, the structure of the multiple line grid array package of the present embodiment is described in detail herebelow.

As shown in Fig. 3A, one of the multiple line grids 11 used in the multiple line grid array package of the present invention is a rectangular type.

The multiple line grid 11 includes a plurality of conductors 10a, a plurality of grooves H and a grid body 9. On outer sides of the multiple line grid 11, a plurality of grooves H are formed parallel to the longitudinal direction of the multiple line grid 11. The conductor 10a is provided on the outer sides between the adjacent grooves H to facilely transfer the electrical signal. Preferably, the inner portion of the multiple line grid 11, that is, a grid body 9 is formed of nonconductive materials such as ceramic, polymer, a composite of ceramics and polymers, and silicon. Furthermore, in this embodiment, four grooves H are formed on the outer sides of the multiple line grid 11 at regular intervals.

In addition, the multiple line grid 11 can be in various forms according to an aspect ratio which is the ratio of a width nₓ, n_{y} to a height n_{z} of the multiple line grid 11. Accordingly, in the multiple line grid array package of the present invention, the multiple line grid 11 may be formed into a rectangular disc type in which the width nₓ, n_{y} is relatively longer than the height n_{z} as shown in Fig. 3A, or alternatively, the multiple line grid 11 may be formed into a rod type in which the width nₓ, n_{y} is relatively shorter than the height n_{z} as shown in Fig. 3B.

Furthermore, the multiple line grid 11 may be formed into other types instead of the rectangular disc or rod type described above.

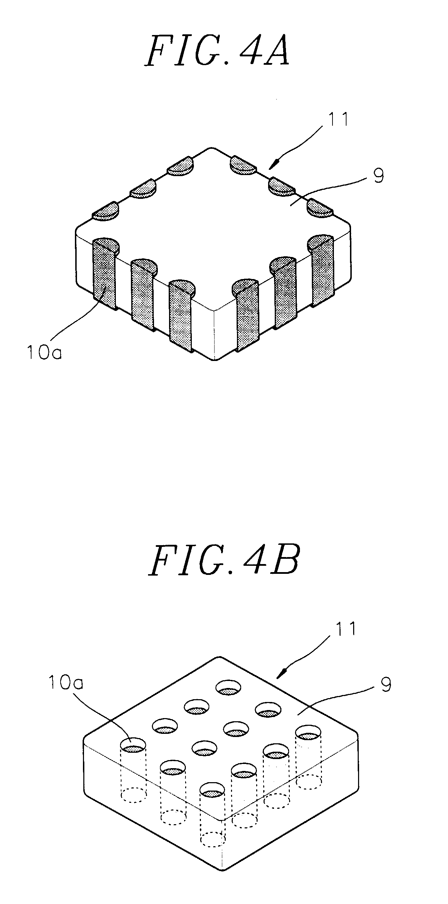

Figs. 4A to 4C are enlarged perspective views which show other embodiments of the multiple line grid 11 which are applicable to the multiple line grid array packages according to this invention.

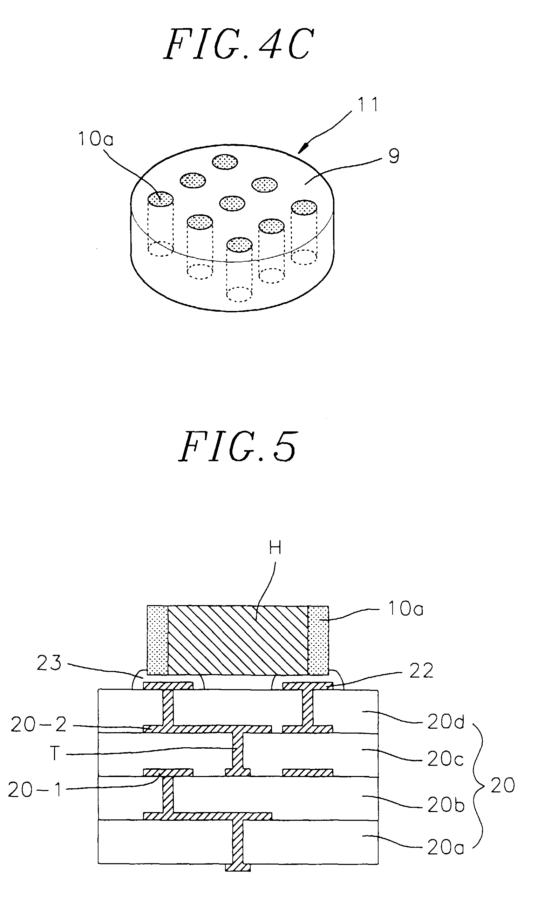

Multiple line grids comprising a nonconductive grid body 9 and conductors 10a of disc type are shown in Figs. 4A to 4C. In Fig. 4A, a number of conductors 10a of semi-circular cylinder shape are formed parallel to the longitudinal direction of the multiple line grid 11 at a peripheral portion of the nonconductive grid body 9, with the conductors being electrically isolated from each other. In FIG 4B, a number of conductors 10a of circular cylinder shape are formed within the nonconductive grid body 9 with the conductors 10a being electrically isolated from each other. In Fig. 4C, a multiple line grid 11 is shown where a number of conductors 10a of circular cylinder shape are formed within a nonconductive grid body 9 of a circular disc shape. Again, the conductors 10a are also electrically isolated from each other.

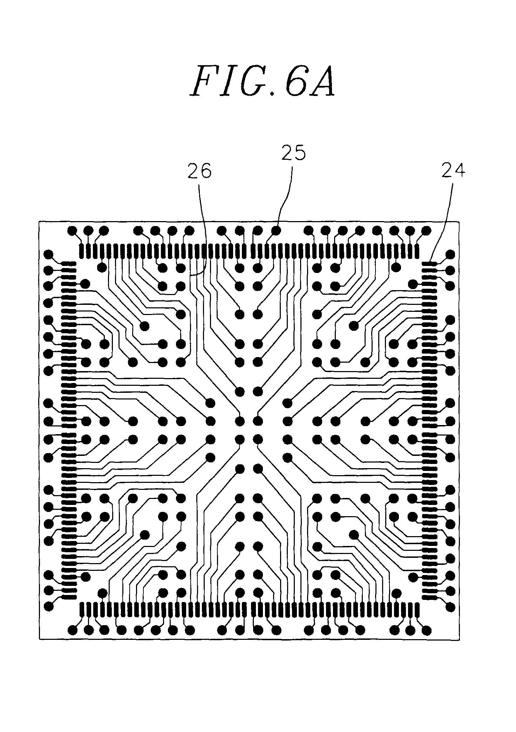

The conductors 10a shown in Fig. 4A may be formed to completely fill holes where the conductors 10a are to be formed to protrude outwardly from top and bottom surfaces of the grid body 9. Alternatively, as shown in Figs. 4B and 4C, the conductors 10a may be formed to intrude from top and bottom surfaces of the grid body 9, i.e., partially fill the holes, or may be formed to just cover internal surface of the holes. As a result, the multiple line grid 11 is attached to the package body 20 in such a way that each of the various shape of conductors 10a positionally or electrically matches the corresponding unit input/output node 22(refer to Fig.5). The nonconductive grid body and the conductor may be modified to other various shapes. Some examples of the grid body and the conductor shown in Figs. 3 and 4A to 4C are not limiting, but illustrative.

According to the present invention, each of the conductors 10a coated with the conductive material or located within the interior of the multiple line grid body shown in Figs. 3 to 4 serves as a unit multiple line grid in a conventional sense. Therefore, one multiple line grid 11 includes a number of leads according to the number of the conductors 10a and can be thus connected with a number of input/output nodes. For example, the multiple line grid 11 of the rectangular disc type has eight conductors 10a as shown in Fig. 4A. Eight input/output nodes are connected with one multiple line grid 11, whereby the number of the multiple line grids which are used in the conventional BGA, PGA and QFP packages can be reduced to one-eighth and the surface area thereof can be also reduced to below one-fourth. In addition, the same concept can be applied to the multiple line grids shown in Figs. 3B to 4C.

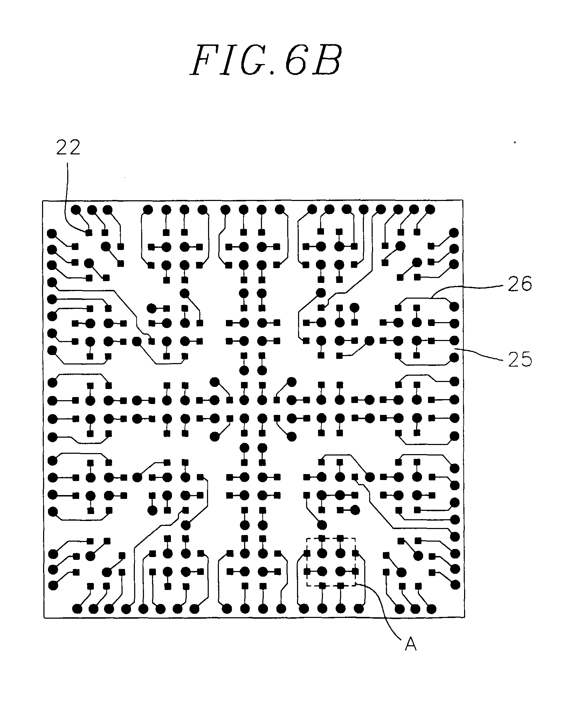

Fig. 5 is a cross-sectional view taken along the line IV-IV' of Fig. 2. As shown in Fig.5, the package body 20 includes four layers 20a, 20b, 20c, and 20d, each of which includes a nonconductive substrate, and metallic electrode lines 20-1, 20-2, and the via holes. The top layer 20d further includes input/output nodes 22 on the surface thereof. On the bottom surface of the lowest layer 20a there is provided bottom pattern(refer to Fig. 6A) . On the top surface of the most top layer 20d, there is also provided a top pattern(refer to Fig. 6B), includes a plurality of input/output nodes 22 which are electrically connected to the corresponding conductors of the multiple line grid 11.

Each of the package layers is laminated to each other and the via holes are coated or filled with conductive paste T. On the upper face of each of the package layers 20a, 20b, 20c, 20d, there are printed the electrodes 20-1, 20-2. And the input/output nodes 22 are exposed to the upper face of the package body 20.

According to the present invention, one multiple line grid 11 is connected with the same number of the input/output nodes 22 as that of the conductors 10a which are formed on the outer sides or interior of the multiple line grid 11. For example, in the embodiment shown in Fig. 3A, since four grooves H are formed on the outer sides of one multiple line grid 11 in the form of rectangular disc, the multiple line grid 11 can be connected with eight input/output nodes 22. At this time, the input/output nodes 22 are bonded to the conductors 10a coated on the outer sides of the multiple line grid 11 by solder 23, as shown in Fig. 5. Although two nodes 22 are shown in Fig. 5, the multiple line grid 11 is connected to the same number of the input/output nodes 22 as those of the conductors 10a which are formed on the outer sides of the multiple line grid 11, as described above.

The multiple line grid according to the present invention may be applied to array type packages, chip scale packages, flip chip packages, wafer level packages, and connectors.

Figs. 6A and 6B are plan views showing electrical circuit patterns printed on bottom and top surfaces of the package body, respectively. The electrical circuit patterns on the package body 20 can be in various forms depending on the types of multiple line grid 11 and IC chips used. One example of such patterns are described in the following.

The most bottom layer of the package body 20 has a nonconductive substrate and a pattern on the surface of the substrate as shown in Fig. 6A. The pattern includes a number of wire bond pads 24, via hole pads 25, and electrode lines 26. The wire bond pads 24 are formed such that the package body 20 is connected to the semiconductor chip by a wire bonding or other connecting methods such as redistribution of wafer level packaging method and C4 (Controlled Collapsed Chip Connection) method. The via hole pads 25 serve to provide the electrical connection between the package layers and the electrode lines 26 electrically connecting the wire bond pads 24 and the via hole pads 25. The wire bond pads 24 may be located on any area of the package body 20.

The pattern shown in Fig. 6B will be described hereinafter. The pattern shown in Fig. 6B is not limiting but illustrative. The electrical circuit pattern is designed by the following design rules.

For example, in the case that the multiple line grid includes eight conductors, input/output nodes 22 are, as shown in Fig. 5B, formed in such a way that each of the input/output nodes 22 corresponds to each of the conductors 10a of the multiple line grid 11. The conductors 10a and input/output nodes 22 are connected by soldering.

As shown in Fig. 6B, the configuration of the input/output nodes 22 is a rectangular shape. In addition, the configuration of the input/output nodes may be in various other shapes such as circular shape, etc. and may have various sizes depending on the shape and the size of the multiple line grid 11. Some of the via hole pads 25 and the electrode lines 26 are positioned outside an area A where the multiple line grid is located and while remaining via hole pads and electrode lines 26 are positioned within an area A. Alternatively, all via hole pads, ground pads and electrode lines may be positioned within the area A where the multiple line grid is located and may also be positioned at bottom surface of the grid body.

For example, when the design rules of the Fig. 6A and Fig. 6B are such that at most two electrode lines are placed between the two adjacent multiple line grids 11, the input/output node pitch is about 500 micrometers, the via hole diameter is about 200 micrometers, line width and spacing is about 75 micrometers and each of the input/output nodes 22 of rectangular shape has a dimension of about 200 micrometer x 200 micrometer, then 200 input/output nodes 22 can be placed in the package body with two package layers and the dimensions of the package body is about 9.8 millimeters x 9.8 millimeters. This kind of the design rules results in the lower manufacturing cost than any other package design, while giving the smaller package substrate area and footprint area on PCB.

When the multiple line grid array package is surface-mounted on a printed circuit board and the input/output nodes 22 are connected to the input/output nodes 22 on the printed circuit board, the design rules for circuit patterns on the printed circuit board will be the same as the design rules aforementioned.

The patterns described in the present invention may be applied to other types of plastic and ceramic packages such as QFP, BGA, CSP (Chip Scale Packages) and wafer level packages. The patterns described in this invention may be also applied to PCBs(Printed Circuit Board) and ceramic substrates for hybrid ICs.

Besides, the pattern design described in the present invention can also be applied to conventional PCB pattern design.

According to the pattern in the present invention, the input/output nodes can be arranged within a small area and the signal propagation delay can be minimized due to the reduction of the length of the electrode lines.

Referring to Figs. 7A to 7C, the method for manufacturing the one type of multiple line grid used in the multiple line grid array package in accordance with one embodiment of the present invention is to be explained hereinafter.

First, for example, a multiple line grid body 9 of circular disc is formed of a nonconductive material such as ceramic and plastic as shown in Fig. 7A. In addition, the circular disc 9 can be formed into a cylindrical shape in which its height m_{z} is longer than its diameter (mₓ, m_{y}).

Secondly, the conductor 10a is coated on the outer side around the circular disc 9, as shown in Fig. 7B. The conductor 10a can be formed on the outer side of the circular disc 9 by using, for example, electroless plating, conductive paste coating, or conductive paste filling.

Finally, as shown in Fig. 7C, a number of grooves H and a number of conductors 10a parallel to the longitudinal direction m_{z} are formed on the outer side of the circular disc 9 by a cutting process such as diamond saw cutting, laser cutting, ultrasonic cutting or punching, thereby forming the multiple line grid 11 connected to a number of the input/output nodes 22. In this embodiment, the order of the steps of forming the conductor 10a and forming the grooves H parallel to the axial direction m_{z} on the outer side of the circular disc 9 can be varied.

Since a number of the grooves H parallel to the axial direction m_{z} are formed on the outer side of the multiple line grid 11, the conductor 10a coated on the outer side of the multiple line grid 11 are separated independently from each other by the inner portion of the nonconductive circular disc 9. Each of such insulated conductors 10a is a unit lead to be connected to a single node. One multiple line grid 11 is connected with a number of nodes.

Furthermore, in the method of forming the multiple line grid according to the present invention, it is possible and viable to use a flexible ceramic green sheet, a fired ceramic substrate or silicon wafer as the material for the multiple line grid. Alternatively, the multiple line grid 11 may be made of a ceramic, a polymer, a silicon, or a compound of ceramic and plastic material.

According to the present invention, although the multiple line grid used in the multiple line grid array package is described in the form of the rectangular or circular disc in the preferred embodiments, the multiple line grid can also have various shapes such as a cylinder, an elliptical disc, a hexahedron disc and cylindrical types of aforementioned shapes.

Moreover, the package body can be formed of a plastic and/or ceramic structures.

As described above in detail, according to the present invention, one multiple line grid can be connected with a number of the input/output nodes, whereby the number of multiple line grids can be reduced considerably, facilitating in reducing the manufacturing cost as well as the size of package.

Furthermore, in order to connect the input/output nodes with the multiple line grid of the invention, the soldering process is applied instead of the brazing process, thereby further reducing the manufacturing cost.

The single multiple line grid of the invention can be connected with a number of the input/output nodes, whereby it can be facilely applied to the highly integrated semiconductor packages.

Having described the preferred embodiments of the present invention, it will appear to those ordinary skilled in the art that various modifications may be made to the disclosed embodiments, and that such modifications are intended to be within the scope of the present invention.

## Claims

1. A multiple line grid array package comprising:
a package body including at least a layer and having a first surface and a second surface parallel to the first surface;
a first pattern formed on the first surface of the package body and including a number of input/output nodes;
a second pattern formed on the second surface of the package body; and
at least a multiple line grid having a nonconductive grid body and a number of conductors, each of the conductors being electrically isolated from each other and is electrically connected to each of the input/output nodes of the first pattern.

2. The package of claim 1, wherein the multiple line grid is formed into one of a rectangular disc, a circular disc, an elliptical disc, a hexahedron disc and a cylinder.

3. The package of claim 2, wherein each of the conductors is formed parallel to a longitudinal direction of the nonconductive grid body on the outer portion and/or within the inner portion of the multiple line grid.

4. The package of claim 3, wherein each of the conductors is formed to completely fill a hole where said conductor is to be located and to protrude outwardly from the top and bottom surface of the nonconductive grid body.

5. The package of claim 3, wherein each of the conductors is formed to partially fill a hole where said conductor is to be located and to intrude inwardly from the top and bottom surface of the nonconductive grid body.

6. The package of claim 3, wherein each of the conductors is formed to just cover internal surface of a hole where said conductor is to be located.

7. The package of claim 1, wherein the nonconductive grid body of the multiple line grid is formed from the group consisting of a ceramic, a polymer, a composite material of ceramics and polymers, or silicon.

8. The package of claim 1, wherein each of the conductors is bonded to the corresponding input/output node by soldering.

9. The package of claim 1, wherein the package body comprises at least one layers formed from the group consisting of a ceramic layer, a polymer layer, a composite layer of ceramics or polymers.

10. The package of claim 1, wherein the first pattern formed the first surface of the package comprises a number of electrode lines, wire bond pads, and via hole pads, ground pads and input/output nodes.

11. The package of claim 10, wherein the input/output nodes form various configurations in the first pattern depending on the position of the corresponding conductors of the multiple line grid, some of the electrode lines are positioned in the first pattern within an area where the multiple line grid is located and the remaining electrode lines are positioned in the first pattern outside the area, and some of the number of via hole pads and ground pads are positioned in the first pattern within the area and the remaining of the via hole pads and ground pads are positioned in the first pattern outside within the area.

12. The package of claim 10, wherein the input/output nodes form various configurations in the first pattern depending on the position of the corresponding conductors of the multiple line grid, and all the electrode lines, via hole pads and ground pads are positioned in the first pattern within said area.

13. The package of claim 11, wherein the first pattern is applicable to QFP, BGA, CSP, flip chip packages and wafer level packages, printed circuit board and ceramic substrate for hybrid ICs.

14. The package of claim 12, wherein the first pattern is applicable to QFP, BGA, CSP, flip chip packages and wafer level packages, printed circuit boards and ceramic substrates for hybrid ICs.

15. A multiple line grid array package comprising:
a package body having a number of input/output nodes; and
at least a multiple line grid having a nonconductive grid body and a number of conductors formed parallel to a longitudinal direction of the nonconductive grid body on the outer peripheral portion and/or within the inner portion of the multiple line grid, wherein each of conductors is electrically isolated from each other and is bonded to a corresponding input/output node in the number of input/output nodes.

16. The package of claim 15, wherein the package body includes at least one layer.

17. The package of claim 16, wherein the package body formed one layer from the group consisting of a ceramic layer, a polymer layer, a composite layer of ceramics and polymers.

18. The package of claim 15, wherein the input/output nodes include various configurations depending on the position of the corresponding conductors of the multiple line grid.

19. The package of claim 15, wherein the multiple line grid is formed into one of a rectangular disc, a circular disc, a cylinder, an elliptical disc, a hexahedron disc and a cylinder.

20. The package of claim 19, wherein the height of the multiple line grid is the same as its width or longer than its width.

21. The package of claim 19, wherein the height of the multiple line grid is shorter than its width.

22. The package of claim 15, wherein a material for the nonconductive grid body of the multiple line grid is formed from the group consisting of a ceramic, a polymer, a composite material of ceramics and polymers, and silicon.

23. The package of claim 15, wherein each of the conductors is electrically connected to the corresponding input/output node by soldering.

24. The package of claim 15, wherein the multiple line grid is applicable to array type packages, chip scale packages, flip chip packages, wafer level packages, and connectors.

25. A method for manufacturing a multiple line grid array package comprising the steps of:
preparing a package body having a first and a second parallel surfaces;
forming a first pattern having a number of input/output nodes on the first surface of the package body;
forming a second pattern on the second parallel surface;
forming a multiple line grid having a nonconductive grid body and a number of conductors; and
connecting each of the conductors of the multiple line grid to each of the input/output nodes of the first pattern.

26. The method of claim 25, wherein the package body comprises at least one layers selected from the group consisting of a ceramic layer, a polymer layer, a composite layer of ceramics and polymers.

27. The method of claim 25, wherein the step for forming the multiple line grid comprises the steps of:
forming a multiple line grid body having a shape with a nonconductive material;
coating the outer side of the multiple line grid body with an electrically conducting material; and
forming a number of grooves parallel to longitudinal direction of the multiple line grid body on outer sides thereof, thereby forming the multiple line grid including the nonconductive grid body and the number of conductors.

28. The method of claim 27, wherein the nonconductive material of the multiple line grid body is selected from the group consisting of a ceramic, a polymer, a composite material of ceramics and polymers, and silicon.

29. The method of claim 27, wherein the shape of the multiple line grid body is one of a rectangular disc, a circular disc, a cylinder, an elliptical disc, a hexahedron disc and a cylinder.

30. The method of claim 27, wherein the step of forming the number of grooves is achieved by one of a diamond saw cutting, a laser cutting, an ultrasonic cutting and a punching processes.

31. The method of claim 25, wherein the step for forming the multiple line grid comprises the steps of:
forming a multiple line grid body having a shape with a nonconductive material;
forming a number of holes on the multiple line grid body parallel to longitudinal direction thereof; and
filling the number of holes with an electrically conducting material, thereby forming the multiple line grid including the nonconductive grid body and the number of conductors.

32. The method of claim 31, wherein the nonconductive material of the multiple line grid body is selected from the group consisting of a ceramic, a polymer, a composite material of ceramics and polymers, and silicon.

33. The method of claim 31, wherein the shape of the multiple line grid body is one of a rectangular disc, a circular disc, an elliptical disc, a hexahedron disc and a cylinder.

34. A multiple line grid array package substantially as herein described, with reference to, or as illustrated in Figures 2, 3A to 3B, 4A to 4C, 5, 6A to 6C and 7A to 7C of the accompanying drawings.
